# EUROPÄISCHE PATENTSCHRIFT

(11) **EP 3 986 970 B1**
(45) Veröffentlichungstag und Bekanntmachung des Hinweises auf die Patenterteilung: **02.10.2024**
(21) Anmeldenummer: 20761787.9
(22) Anmeldetag: 24.08.2020
(51) Int. Cl.: C09D 11/101, C09D 11/38, B41M 1/34

(54) **DRUCKSUBSTANZ ZUR BESCHICHTUNG VON GLASOBERFLÄCHEN**
PRINTING SUBSTANCE FOR COATING GLASS SURFACES
SUBSTANCE D'IMPRESSION PERMETTANT DE REVÊTIR DES SURFACES DE VERRE

(30) Priorität: 27.08.2019 DE 102019123000
(43) Veröffentlichungstag der Anmeldung: 27.04.2022
(73) Patentinhaber: Ferro GmbH, 60327 Frankfurt am Main (DE)
(72) Erfinder: KHAN, Marya, 63225 Langen (DE); SCHULZ, Andreas, 61184 Karben (DE); ARNOLD, Charlotte, 64285 Darmstadt (DE); KÜHNAPFEL, Michelle, 63853 Mömlingen (DE)
(74) Vertreter: Gille Hrabal Partnerschaftsgesellschaft mbB Patentanwälte
(86) Internationale Anmeldenummer: PCT/EP2020/073593
(87) Internationale Veröffentlichungsnummer: WO 2021/037778

(56) Entgegenhaltungen:
- EP-A1- 2 623 575
- WO-A1-2006/056781
- WO-A1-2007/048819
- WO-A1-2018/070654
- WO-A1-2018/106086
- WO-A1-2019/132486
- US-A1- 2006 019 077
- US-A1- 2010 068 407

## Beschreibung

Die vorliegende Erfindung betrifft Drucksubstanzen zur Beschichtung von Glasoberflächen, ein Verfahren zur Herstellung dieser Drucksubstanzen sowie eine Verwendung dieser Drucksubstanzen.

In jüngerer Zeit werden vermehrt UV-härtende organische Farben anstelle der früher verwendeten keramischen (anorganischen) Farben für das Bedrucken von Glas eingesetzt. Dies eröffnet die Möglichkeit, ohne Schwermetalle auszukommen, über eine größere Farbtonpalette (Standard- und Mischtöne) zu verfügen, eine größere Brillanz und einen erhöhten Glanzgrad zu erzielen. Ein weiterer Vorteil ist die Möglichkeit, den Farbton direkt nach der UV-Härtung zu beurteilen. Im Gegensatz dazu ist bei den anorganischen Farben die Beurteilung erst nach dem Einbrennen möglich. Weiter bieten sie Verfahrensvorteile. So kann auf einen Temperierungsprozess verzichtet werden, was die Verfahrenskosten gegenüber Verfahren mit anorganischen Druckfarben verringert. Anorganischen Druckfarben werden einem Temperierungsprozess unterzogen, der im Allgemeinen ca. 90 min dauert und bei einer Temperierungstemperatur im Bereich von 500-700°C durchgeführt wird.

Druckfarben und Druckverfahren, mit denen Dekore auf unterschiedlichen Substraten erzeugt werden können, sind beispielsweise aus den Druckschriften DE 10 349 394 A1, WO 2014/123706 A1, WO 01/32789 A1, US 2017/298241 A1, KR 20180014115, WO 2016/048117, CN 106147381 A, JP 2007270089 A, US 2010/035003 A1, US 2014/031446 A1 und WO 98/43134 A1 bekannt. Die WO2018070654 beschreibt eine Tintenzusammensetzung für den Tintenstrahldruck, welche eine Epoxykomponente, eine Oxetankomponente, eine Vinyletherkomponente, einen Haftvermittler und einen Initiator enthält.

Weiterhin sind Druckfarben bekannt, die mittels Tintenstrahldruck auf Glasflaschen aufgebracht werden, um ein Dekor zu erzeugen. Diese sind unter anderem von Mankiewicz und Marabu kommerziell erhältlich. Allerdings benötigen diese Systeme, um den üblichen Anforderungen an die Haftung, Kratzfestigkeit, Abbildungsgenauigkeit und Beständigkeit, insbesondere Wasser- oder Lösungsmittelbeständigkeit zu erfüllen, eine Grundierung (Primerschicht) sowie einen Schutzlack (Deckschicht).

Die bekannten Druckfarben können gemäß den zuvor dargelegten Verfahren zum Bedrucken von Glas eingesetzt werden. Allerdings ist vielfach das Auftragen einer Grundierung (Primer) auf das Glas notwendig, um eine ausreichende Haftung zu erzielen. Ohne diese Vorbehandlung wird keine ausreichende Haftung erreicht. In einigen der zuvor dargelegten Dokumente wird behauptet, dass eine Vorbehandlung mit einem Haftverbesserer nicht notwendig wäre. Allerdings zeigen diese Druckfarben eine Haftung, die verbesserungswürdig ist. Ferner sind Dekore, die mit bekannten Druckfarben erhalten wurden, nicht sehr kratzfest und zeigen eine relativ geringe Lösungsmittelbeständigkeit, so dass übliche Deckschichten auf ein erhaltenes Dekor aufgebracht werden.

In Anbetracht des Standes der Technik ist es nun Aufgabe der vorliegenden Erfindung, eine Drucksubstanz zur Beschichtung von Glasoberflächen mit einem Tintenstrahldruckverfahren bereitzustellen, welche auf einem Glassubstrat eine hohe Haftung zeigt, ohne dass auf das Glassubstrat eine Grundierung (Primer) aufgetragen wird. Weiterhin sollte die Drucksubstanz nach dem Auftragen nach sehr kurzer Zeit in einer Weise aushärtbar sein, dass das bedruckte Glassubstrat seinem Verwendungszweck zugeführt werden kann.

Darüber hinaus sollte das durch die Drucksubstanz erhaltene Dekor eine möglichst hohe Lösungsmittel- und Kratzbeständigkeit, insbesondere Alkohol- und Kratzbeständigkeit aufweisen. Insbesondere sollte das Dekor üblichen Belastungen ohne einen Schutzlack standhalten. Ferner sollte die Drucksubstanz möglichst einfach und kostengünstig erhalten werden können. Ferner sollte das hierauf beruhende Druckverfahren mit geringen Kosten und hoher Effizienz durchgeführt werden können. Insbesondere sollte das Druckverfahren mit möglichst hohen Durchsatzraten ausgeführt werden können, wobei insbesondere kurze Härtungszeiten erreicht werden sollten. Ferner sollte die Drucksubstanz einen möglichst geringen Wartungsaufwand an den Druckmaschinen verursachen. So sollte die Drucksubstanz insbesondere nicht dazu führen, dass bei einem Tintenstrahldrucker die Druckdüsen leicht verstopfen. Weiterhin sollte das Dekor, welches durch das Verfahren erhalten werden kann, eine hohe Abbildungsschärfe aufweisen. Darüber hinaus sollte die Drucksubstanz für die Verwendung in einem Tintenstrahldrucker eingesetzt werden können.

Gelöst werden diese sowie weitere nicht explizit genannten Aufgaben, die jedoch aus den hierin einleitend diskutierten Zusammenhängen ohne weiteres ableitbar oder erschließbar sind, durch eine Drucksubstanz mit allen Merkmalen des Patentanspruchs 1. Zweckmäßige Abwandlungen der erfindungsgemäßen Drucksubstanz werden in Unteransprüchen unter Schutz gestellt. Hinsichtlich der Verfahren zur Herstellung und Verwendung der Drucksubstanz stellen die Gegenstände der Ansprüche 15 bis 20 eine Lösung der zugrunde liegenden Aufgabe bereit.

Gegenstand der vorliegenden Erfindung ist eine Drucksubstanz zur Beschichtung von Oberflächen, vorzugsweise Kunststoffoberflächen oder Glasoberflächen, besonders bevorzugt Glasoberflächen mit einem Tintenstrahldruckverfahren, umfassend
A) zumindest ein Monomer mit mindestens einer C-C-Doppelbindung;
B) zumindest ein kationisch härtbares Monomer, welches Epoxygruppen umfasst;
C) zumindest ein kationisch härtbares Monomer, welches Oxetangruppen umfasst;
D) zumindest einen Haftvermittler, wobei die Komponenten A) und D) wie in Anspruch 1 definiert sind.

Durch diese Ausgestaltung können Kunststoffoberflächen oder Glasoberflächen, bevorzugt Glasoberflächen mit einem Tintenstrahldruckverfahren bedruckt werden, wobei das erhaltene Dekor auf einem Kunststoff- oder Glassubstrat, vorzugsweise Glassubstrat eine hohe Haftung zeigt, ohne dass das Kunststoff- oder Glassubstrat, vorzugsweise Glassubstrat eine Grundierung benötigt. Weiterhin ist die Drucksubstanz nach dem Auftragen nach sehr kurzer Zeit in einer Weise so aushärtbar, dass mehrere Farben hintereinander, diese Farben nebeneinander und übereinander gedruckt werden können und dass das bedruckte Glassubstrat seinem Verwendungszweck zugeführt werden kann.

Darüber hinaus weist das durch die Drucksubstanz erhaltene Dekor eine sehr hohe Lösungsmittel- und Kratzbeständigkeit, insbesondere Alkohol- und Kratzbeständigkeit auf. Insbesondere hält das Dekor üblichen Belastungen ohne einen Schutzlack stand. Überraschend genügt eine nach sehr kurzer Zeit erzielbare Oberflächenhärte den üblichen Anforderungen, die in einer maschinellen Abfüllanlage gegeben sein müssen. So kann ein Kunststoff- oder Glasbehälter, vorzugsweise ein Glasbehälter in einer Abfüllanlage mit einer erfindungsgemäßen Drucksubstanz bedruckt und anschließend mit einer Flüssigkeit befüllt werden, ohne dass die Bedruckung verkratzt werden würde. Eine Durchhärtung der Beschichtung, beispielsweise einer Bedruckung wird im Allgemeinen innerhalb von 24 Stunden bis 5 Tagen erreicht, so dass die maximale Lösungsmittel- insbesondere Alkoholresistenz erst zu einem späteren Zeitpunkt erreicht wird. Dies ist insofern unkritisch, da die befüllten Behälter erst zu einem späteren Zeitpunkt dem Endkunden übergeben werden.

Ferner kann die Drucksubstanz einfach und kostengünstig erhalten werden, wobei das hierauf beruhende Druckverfahren sehr einfach mit bekannten Anlagen durchgeführt werden kann. Weiterhin ist das Druckverfahren mit sehr hohen Durchsatzraten ausführbar, wobei insbesondere kurze Härtungszeiten erreicht werden. Ferner ermöglicht die Drucksubstanz einen sehr geringen Wartungsaufwand an den Druckmaschinen. So führt die Drucksubstanz insbesondere nicht dazu, dass bei einem Tintenstrahldrucker die Druckdüsen leicht verstopfen. Weiterhin weist das Dekor, welches durch das Verfahren erhalten werden kann, eine hohe Abbildungsschärfe auf. Darüber hinaus kann die Drucksubstanz für die Verwendung in einem Tintenstrahldrucker ausgebildet werden.

Die Drucksubstanz zur Beschichtung von Glasoberflächen mit einem Tintenstrahldruckverfahren, umfasst zumindest ein Monomer mit C-C-Doppelbindungen als Komponente A). Monomere mit mindestens einer C-C-Doppelbindung sind aus dem Stand der Technik bekannt. Diese Monomere können über einen radikalischen Mechanismus und/oder einen kationischen Mechanismus polymerisiert werden. Hierbei können diese Monomere eine, zwei oder mehr C-C-Doppelbindungen umfassen. Zu diesen Monomeren gehören beispielsweise Olefine, Vinylmonomere, wie Vinylchorid, Styrol, Vinylethermonomere, (Meth)acrylate und Itaconate.

Einzusetzende Monomeren mit mindestens einer C-C-Doppelbindung sind (Meth)acrylate. (Meth)acrylate sind in der Fachwelt weithin bekannt und kommerziell erhältlich. Eingesetzt werden cyclische (Meth)acrylate, besonders bevorzugt sind die cyclischen (Meth)acrylate ausgewählt aus Isobornylacrylat, t-Butylcyclohexylacrylat, 2-Phenoxyethylacrylat, (5-Ethyl-1,3-dioxan-5-yl)methylacrylat (cyclo-Trimethylolpropanformalacrylat). Durch die Verwendung von cyclischen (Meth)acrylaten lassen sich überraschende Vorteile in Bezug auf Haltbarkeit, Härtbarkeit und Druckeigenschaften der Drucksubstanz erzielen.

Bei den Itaconaten kann es sich um Itaconpolyesterpolyole, Itaconpolyesteracrylate oder Itaconpolyesterglycidylmethacrylate handeln, Weitere Informationen hierzu finden sich unter anderem in der Masterarbeit von Arjete Hasanaj: Entwicklung einer UV-härtenden Druckfarbe für Glas aus nachwachsenden Rohstoffen, Hochschule RheinMain Wiesbaden Rüsselsheim, Fachhochschule Frankfurt am Main, 2013. Die Druckschrift Arjete Hasanaj: Entwicklung einer UV-härtenden Druckfarbe für Glas aus nachwachsenden Rohstoffen, Hochschule RheinMain Wiesbaden Rüsselsheim, Fachhochschule Frankfurt am Main, 2013 wird zu Offenbarungszwecken in die vorliegende Anmeldung durch Referenz hierauf eingefügt.

Weiterhin gehören Vinylethermonomere zu den einzusetzenden Monomeren mit mindestens einer C-C-Doppelbindung. Vinylethermonomere in der Fachwelt weithin bekannt und kommerziell erhältlich. Bevorzugt sind insbesondere Triethylenglycoldivinylether, Diethylenglycoldivinylether, 1,4-Cyclohexandimethanoldivinylether, 1,4-Butandiolmonovinylether, 1,4-Butandioldivinylether und Ethylenglycolmonovinylether. Durch die Verwendung von Vinylethermonomeren lassen sich überraschende Vorteile in Bezug auf Haltbarkeit, Härtbarkeit und Druckeigenschaften der Drucksubstanz erzielen.

Die Monomere mit mindestens einer C-C-Doppelbindung gemäß Komponente A) werden als Mischung eingesetzt.

Die Mischungen umfassen mindestens ein cyclisches (Meth)acrylat und ein Vinylethermonomer.

Vorzugsweise kann vorgesehen sein, dass das Monomer mit mindestens einer C-C-Doppelbindung eine Monomerenmischung darstellt, welche mindestens ein (Meth)acrylat und mindestens ein Vinylethermonomer umfasst und das molare Verhältnis von (Meth)acrylat zu Vinylethermonomer im Bereich von 20:1 bis 1:20, vorzugsweise im Bereich von 6:1 bis 1:6, besonders bevorzugt im Bereich von 2:1 bis 1:2 liegt. Monomere, die sowohl eine (Meth)acrylat-Gruppe als auch eine Vinylether-Gruppe besitzen, werden hierbei zu beiden Monomerarten gezählt unabhängig von der Anzahl der jeweiligen Gruppen.

Ferner kann das Monomer mit mindestens einer C-C-Doppelbindung gemäß Komponente A) mindestens ein vernetzendes Monomer umfassen. Radikalisch und/oder kationisch härtbare Monomere gemäß Komponente A), die eine Vernetzung bewirken, umfassen mindestens zwei C-C-Doppelbindungen, die über einen radikalischen und/oder kationischen Mechanismus polymerisierbar sind. Hierbei können die mindestens zwei C-C-Doppelbindungen eine identische Reaktivität aufweisen, wie beispielsweise 1,4-Butandioldivinylether oder eine unterschiedliche Reaktivität, wie beispielsweise Vinyl(meth)acrylat. Zu den bevorzugten vernetzenden Monomeren gehören (Meth)acrylate mit mindestens zwei (Meth)acrylatgruppen und Vinylmonomere, vorzugsweise Vinylethermonomere mit mindestens zwei Vinylgruppen. Hierbei sind unter anderem Triethylenglycoldivinylether, Diethylenglycoldivinylether, 1,4-Cyclohexandimethanoldivinylether, 1,4-Butandioldivinylether bevorzugt. Speziell bevorzugt sind Mischungen, die mindestens ein Vinylmonomer, vorzugsweise Vinylethermonomer mit mindestens zwei Vinylgruppen und mindestens ein nicht-vernetzendes (Meth)acrylat aufweisen.

Ferner kann vorgesehen sein, dass das Monomer mit mindestens einer C-C-Doppelbindung eine Monomerenmischung darstellt, welche mindestens ein radikalisch härtbares Monomer und mindestens ein kationisch härtbares Monomer umfasst. Bevorzugte radikalisch härtbare Monomere mit mindestens einer C-C-Doppelbindung sind (Meth)acrylate; bevorzugte kationisch härtbare Monomere mit mindestens einer C-C-Doppelbindung sind Vinylethermonomere. Hierbei ist dem Fachmann bekannt, dass Vinylethermonomere ebenfalls über einen radikalischen Mechanismus härtbar sind. Daher stellt eine Monomerenmischung, welche mindestens ein radikalisch härtbares Monomer und mindestens ein kationisch härtbares Monomer umfasst, eine Mischung mit verschiedenen Monomeren dar, deren Härtbarkeit im Hinblick auf die Art des Mechanismus, d.h. die Reaktionsgeschwindigkeit unter entsprechenden Bedingungen (kationisch beziehungsweise radikalisch) unterschiedlich ist.

Vorzugsweise kann vorgesehen sein, dass das Monomer mit mindestens einer C-C-Doppelbindung eine Monomerenmischung darstellt, welche mindestens ein vernetzendes Monomer und mindesten ein nicht-vernetzendes Monomer umfasst und das molare Verhältnis von vernetzendem Monomer zu nicht- vernetzendem Monomer im Bereich von 20:1 bis 1:20, vorzugsweise im Bereich von 4:1 bis 1:6, besonders bevorzugt im Bereich von 3:2 bis 1:2 liegt.

Die Drucksubstanz zur Beschichtung von Glasoberflächen mit einem Tintenstrahldruckverfahren umfasst zumindest ein kationisch härtbares Monomer mit Epoxygruppen als Komponente B). Kationisch härtbare Monomere mit Epoxygruppen sind aus dem Stand der Technik weithin bekannt und kommerziell erhältlich. Epoxygruppen sind Oxiranreste, die einen Dreiring mit einem Sauerstoffatom darstellen. Kationisch härtbare Monomere mit Epoxygruppen können durch Oxidation von entsprechenden Alkenen mit Sauerstoff erhalten werden (Epoxidierung).

Als kationisch härtbare Monomere, welche Epoxygruppen umfassen, sind aliphatische Epoxide bevorzugt. Weiterhin sind als kationisch härtbare Monomere, welche Epoxygruppen umfassen, cycloaliphatische Epoxide bevorzugt. Aliphatische und/oder cycloaliphatische Epoxide enthalten vorzugsweise keine heteroaromatischen oder aromatischen Gruppen, wie zum Beispiel Bisphenol A.

Das kationisch härtbare Monomer, welches Epoxygruppen umfasst, kann ein, zwei, drei oder mehr Epoxygruppen enthalten. Gemäß Komponente B) einzusetzende kationisch härtbare Monomere, welche Epoxygruppen umfassen, können einzeln oder als Mischung eingesetzt werden, wobei Mischungen bevorzugt sind. Hierzu gehören Mischungen von unterschiedlichen Monomeren, die genau eine Epoxygruppe aufweisen, Mischungen von unterschiedlichen Monomeren, die mindestens zwei Epoxygruppen aufweisen und Mischungen, die mindestens ein Monomer mit genau einer Epoxygruppe und mindestens ein Monomer mit mindestens zwei Epoxygruppen aufweisen.

Insbesondere kann vorgesehen sein, dass kationisch härtbare Monomere mit Epoxygruppen beziehungsweise die Komponente B) mindestens ein Monomer enthält, welches genau eine Epoxygruppe aufweist.

Vorzugsweise kann vorgesehen sein, dass das kationisch härtbare Monomer mit Epoxygruppen beziehungsweise die Komponente B) mindestens ein Monomer enthält, welches mindestens zwei Epoxygruppen aufweist.

Besonders bevorzugt kann vorgesehen sein, dass das kationisch härtbare Monomer, welches Epoxygruppen umfasst, eine Monomerenmischung darstellt, welche mindestens ein vernetzendes Monomer und mindesten ein nicht-vernetzendes Monomer umfasst, wobei das molare Verhältnis von vernetzendem Monomer zu nicht- vernetzendem Monomer bevorzugt im Bereich von 100:1 bis1:5, vorzugsweise 10:1 bis 1:2 liegt. Vernetzende Monomere gemäß Komponente B) weisen mindestens zwei Epoxygruppen auf, während nicht-vernetzende Monomere genau eine Epoxygruppe umfassen.

Ferner kann vorgesehen sein, dass das kationisch härtbare Monomer, welches Epoxygruppen umfasst, mindestens drei Epoxygruppen aufweist. In einer besonderen Ausgestaltung wird eine Mischung von kationisch härtbare Monomeren, welche Epoxygruppen umfassen, eingesetzt, die mindestens ein Monomer mit genau zwei Epoxygruppen und mindestens ein Monomer mit mindestens drei Epoxygruppen umfasst. Vorzugsweise liegt das molare Verhältnis von Monomer mit genau zwei Epoxygruppen zu Monomer mit mindestens drei Epoxygruppen im Bereich von 100:1 bis 1:4, besonders bevorzugt 10:1 bis 1:2.

Die Drucksubstanz zur Beschichtung von Glasoberflächen mit einem Tintenstrahldruckverfahren umfasst zumindest ein kationisch härtbares Monomer, welches Oxetangruppen aufweist, als Komponente C). Kationisch härtbare Monomere mit Oxetangruppen sind aus dem Stand der Technik weithin bekannt und kommerziell erhältlich. Oxetangruppen sind Reste mit einem Sauerstoffatomenthaltenden Vierring. Kationisch härtbare Monomere mit Oxetangruppen können durch eine Paternö-Büchi-Reaktion aus Alkenen und Carbonylen erhalten werden.

Hierzu gehören unter anderem Monomere, wie Bis[1-ethyl(3-oxetanyl)]methylether, 3-Ethyl-3-hydroxymethyloxetan, 1,4-Bis[(3-ethyl-3-oxetanyl)methoxymethyl]benzol, 3-Ethyl-3-(phenoxymethyl)oxetan, Di[(3-ethyl-3-oxetanyl)methyl]ether, 3-Ethyl-3-(2-ethylhexyloxymethyl)oxetan, 3-Ethyl-3-cyclohexyloxymethyloxetan. Als Komponente C) können beispielsweise ARON OXETAN OXT-101, ARON OXETAN OXT-121, ARON OXETAN OXT-211, "ARON OXETAN OXT-221 oder ARON OXETAN OXT-212 verwendet werden, hergestellt von Toagosei Co., Ltd. und dergleichen. Das kationisch härtbare Monomere mit Oxetangruppen kann entweder allein oder in Kombination von zwei oder mehreren verwendet werden.

Vorzugsweise kann vorgesehen sein, dass das kationisch härtbare Monomer, welches Oxetangruppen umfasst, mindestens zwei Oxetangruppen aufweist.

Besonders bevorzugt kann vorgesehen sein, dass das molare Verhältnis von Monomer, welches Epoxygruppen umfasst, zu Monomer, welches Oxetangruppen umfasst, im Bereich von 40:1 bis 1:15, vorzugsweise 30:1 bis 1:10, bevorzugt 25:1 bis 1:8, besonders bevorzugt 20:1 bis 1:5, speziell bevorzugt 10:1 bis 1:1, besonders speziell bevorzugt 6:1 bis 2:1 und ganz bevorzugt 4:1 bis 9:4 liegt.

Ferner kann vorgesehen sein, dass das molare Verhältnis von Monomer mit mindestens einer C-C-Doppelbindung zu kationisch härtbarem Monomer mit einer Epoxy- und/oder Oxetangruppe im Bereich im Bereich von 20:1 bis 1:5, vorzugsweise 10:1 bis 1:3, besonders bevorzugt 5:1 bis 1:2 und speziell bevorzugt 2:1 bis 1:1 liegt.

Bevorzugt kann vorgesehen sein, dass das molare Verhältnis von Monomer mit mindestens einer C-C-Doppelbindung zu Monomer, welches Epoxygruppen umfasst, im Bereich von 20:1 bis 1:4, vorzugsweise 10:1 bis 1:2, besonders bevorzugt 5:1 bis 1:1 und speziell bevorzugt 3:1 bis 3:2 liegt.

Bevorzugt kann weiterhin vorgesehen sein, dass das molare Verhältnis von Monomer mit mindestens einer C-C-Doppelbindung zu Monomer, welches Oxetangruppen umfasst, im Bereich von 40:1 bis 1:2, vorzugsweise 20:1 bis 1:1, besonders bevorzugt 10:1 bis 2:1 und speziell bevorzugt 8:1 bis 3:1 liegt.

Als Komponente D) umfasst die Drucksubstanz zur Beschichtung von Glasoberflächen mit einem Tintenstrahldruckverfahren zumindest einen Haftvermittler, welcher mindestens eine Silanverbindung umfasst. Haftvermittler sind Substanzen, die die Haftung von Beschichtungen auf dem Substrat verbessern. Demgemäß umfassen Haftvermittler Gruppen und/oder Reste, die eine gute Verbindung mit dem Substrat bewirken, und Gruppen und/oder Reste, die eine Verbindung mit der Beschichtung bewirken.

Dabei kann es sich um Isocyanat-Haftvermittler handeln, z.B. um aliphatische Isocyanate sowie Polyisocyanate, bevorzugt Polyisocyanate auf Basis von Hexamethylendiisocyanat (HDI), Trimethylhexandiisocyanat (TMHDI), cycloaliphatische Polyisocyanate wie Isophorondiisocyanat (IPDI), hydriertes Xylylendiisocyanat (HXDI) oder Diisocyanatodicyclohexylmethan (HMDI), sowie aromatische Isocyanate sowie Polyiisocyanate, bevorzugt Polyisocyanate auf Basis von Toluylendiisocyanat (TDI), Xylylendiisocyanat (XDI), Tetramethylxylylendiisocyanat (TMXDI) oder Diisocyanatodiphenylmethan (MDI). Kommerziell erhältliche Produkte sind z.B. Desmodur E41 oder Desmodur N 75 (Covestro). Vinylphosphate oder metallorganische Verbindungen wie Titanate oder Zirkonate können ebenfalls eingesetzt werden

Bevorzugte Gruppen, die mit einem Glassubstrat eine hohe Haftung bewirken, sind unter anderem Silangruppen. Der Haftvermittler gemäss der Anmeldung umfasst mindestens eine Silanverbindung und besteht aus einer oder mehrerer Silanverbindungen.

Zur Bewirkung einer guten Verbindung mit der Beschichtung können bevorzugte Haftvermittler in die Beschichtung einpolymerisiert werden. Bevorzugt kann vorgesehen sein, dass der Haftvermittler eine härtbare Gruppe umfasst. Härtbare Gruppen sind Reste, die bei einer Polymerisationsreaktion reagieren. Hierzu gehören radikalisch polymerisierbare Gruppen und/oder kationisch polymerisierbare Gruppen. Bevorzugt kann vorgesehen sein, dass der Haftvermittler eine Silanverbindung mit einer kationisch oder radikalisch härtbaren Gruppe ist. Die bevorzugten Haftvermittler sind Silan-Haftvermittler, wie Vinylsilane, Methacryloxysilane, Epoxysilane, Chlorsilane und Isocyanatosilane. vorzugsweise Epoxysilane.

Bevorzugte Silan-Haftvermittler enthalten neben einer härtbaren Gruppe mindestens eine vorzugsweise mindestens zwei hydrolysierbare Gruppen, wie beispielsweise Halogenreste, wie Chlor- oder Bromreste und/oder Alkoxygruppen, vorzugsweise Methoxy-, Ethoxy-, Propoxy- und/oder Butoxygruppen, wobei Methoxy- und/oder Ethoxygruppen bevorzugt sind.

Zu den bevorzugten Epoxysilanen gehören unter anderem 2-(3,4-Epoxycyclo-hexyl)ethyltriethoxysilan, 4-(Methyldiethoxysilyl)-1,2-epoxycyclohexan und 3-(3,4-Epoxycyclohexyl)propyltri(isobutoxy)silan, (3,4-Epoxycyclohexyl)ethyltriethoxysilan, 3-Glycidoxypropyldiethoxymethylsilan, 3-Glycidoxypropyltri-(isobutoxy)silan, (3,4-Epoxycyclohexyl)ethyltri-(isobutoxy)silan, 3-Glycidoxypropyltrimethoxysilan und/oder 3-Glycidoxypropyltriethoxysilan.

Vorzugsweise kann vorgesehen sein, dass die Drucksubstanz mindestens 5 Gew. %, vorzugsweise mindestens 6 Gew. % und besonders bevorzugt mindestens 7 Gew. % Haftvermittler umfasst.

Ferner kann vorgesehen sein, dass das molare Verhältnis von Monomer mit mindestens einer C-C-Doppelbindung zu Haftvermittler im Bereich von 40:1 bis 1:2, vorzugsweise 20:1 bis 1:1, besonders bevorzugt 10:1 bis 2:1 und speziell bevorzugt 8:1 bis 3:1 liegt.

Vorzugsweise kann vorgesehen sein, dass das molare Verhältnis von kationisch härtbarem Monomer zu Haftvermittler im Bereich von 20:1 bis 1:2, vorzugsweise 15:1 bis 1:1, besonders bevorzugt 10:1 bis 2:1 liegt.

Bevorzugt kann vorgesehen sein, dass das molare Verhältnis von Monomer, welches Epoxygruppen umfasst, zu Haftvermittler im Bereich von 15:1 bis 1:2, vorzugsweise 10:1 bis 1:1, besonders bevorzugt 8:1 bis 3:2 und speziell bevorzugt 4:1 bis 2:1 liegt.

Bevorzugt kann weiterhin vorgesehen sein, dass das molare Verhältnis von Monomer, welches Oxetangruppen umfasst, zu Haftvermittler im Bereich von 15:1 bis 1:15, vorzugsweise 10:1 bis 1:10, besonders bevorzugt 5:1 bis 1:5 und speziell bevorzugt 2:1 bis 1:2 liegt.

Die Drucksubstanz umfasst härtbare Monomere und wird nach dem Auftragen auf das Substrat gehärtet. Hierbei ist die Drucksubstanz vorzugsweise mit Bestrahlung durch elektromagnetische Wellen, besonders bevorzugt durch UV-Strahlung härtbar, ohne dass hierdurch eine Beschränkung erfolgen soll. Dementsprechend umfasst die Drucksubstanz vorzugsweise einen Initiator, vorzugsweise für eine kationische Härtung und/oder einen Radikalinitiator. Ferner kann vorgesehen sein, dass die Drucksubstanz mindestens einen Photoinitiator umfasst, der vorzugsweise bei einer UV-Strahlung eine Härtung bewirkt. Weiterhin kann vorgesehen sein, dass die Drucksubstanz mindestens einen Sensibilisator umfasst.

Die Drucksubstanz enthält vorzugsweise mindestens einen Photoinitiator, gewöhnlich zwei und möglicherweise drei oder mehr Photoinitiatoren, um die Oberflächen- und Tiefenhärtung (Vernetzung) der Farbe zur Bedruckung von Glas im UV-Licht einzuleiten. Sie können aus den üblichen in UV-härtenden Druckfarben und -lacken usw. verwendeten Photoinitiatoren ausgewählt werden.

Beispiele für kationische UV-Initiatoren sind beispielsweise Aryldiazoniumsalze, Diaryliodoniumsalze, Triarylsulfoniumsalze, Triarylselenoniumsalze, Dialkylphenacylsulfoniumsalze, Aryloxydiarylsulfoxoniumsalze und Diarylphenacylsulfoxoniumsalze. Bevorzugte Beispiele für kationische UV-Initiatoren umfassen Diphenyl (4-phenylthio) phenylsulfoniumhexafloroantimonat, (Thiodi-4,1-phenylen) bis(diphenylsulfonium) dihexafluoroatimonat (eine Mischung dieser Substanzen wird unter der Bezeichnung CHIVACURE ^{®} 1176 von Chitec Technology Co. Ltd., Phoenix Ariz vertriebenen), Diphenyl (4-phenylthio) phenylsulfoniumhexafluorphosphat, (Thiodi-4,1-phenylen) bis (diphenylsulfonium)dihexafluorphosphat (eine Mischung dieser Substanzen wird unter der Bezeichnung CHIVACURE^{®}1190 von Chitec Technology Co. Ltd vertrieben), Triarylsulfoniumhexafluorphosphatsalz (CYRACURE^{®} UVI-6990) und Triarylsulfoniumhexafluoroantimonatsalz (CYRACURE^{®} UVI-6974) (beide erhältlich von Union Carbide Chemicals und Plastics Co. Inc., Danbury, Conn.), Triphenylselenonium Hexafluorantimonat, Triphenylsulfoniumhexafluorantimonat, Triphenylsulfoniumhexafluorophosphat, Bis (4-dodecylphenyl) - iodoniumhexafluorantimonat und η-5-2,4-Cyclopentadien-1-yl) [(1,2,3,4,5,6-η) - (1-Methylethyl) benzen] Eisen (1+) hexafluorphosphat (1-) (IGRACURE ^{®}261 von Ciba-Geigy Corporation, Mclntosh Ala.) und Kombinationen oder zwei oder mehr der zuvor genannten.

Beispiele für radikalische UV-Initiatoren sind beispielsweise 1-Hydroxycyclohexylphenylketon, Benzophenon, 2,4,6-Trimethylbenzophenon, 4-Methylbenzophenon, 2-Benzyl-2-dimethylamino-1-(4-morpholinophenyl) butanon. 1,2-Methyl-1-(4-methylthio) phenyl-2- (4-morpholinyl) -1-propanon, 2,4,6-Trimethylbenzoylphenylphosphinsäureethylester, Oligo (2-hydroxy-2-methy-1-(4- (1-methylvinyl) phenyl) propanon), 2-Hydroxy-2-methyl-1-phenyl-1-propanon, Benzyldimethylketal, Isopropylthioxanthon. 2-Methyl-1-[4-(methylthiophenyl)-2-morpholinopropan]-1-on (Irgacure^{®} 907 von BASF Corporation oder OMNIRAD^{®} 4817 von IGM Resins, Bartlett III.), 1-Hydroxycyclohexylacetophenon (Irgacure^{®} 184 von BASF Corporation), 2-Benzyl-2-dimethylamino-1-(4-morpholinophenyl)butan-1-on (Irgacure^{®} 369 von BASF Corporation), Bis(2,4,6-trimethylbenzoyl)phenylphosphinoxid (Irgacure^{®} 819 von BASF Corporation), 2-Hydroxy-2-methyl-1-phenyl-1-propanon (Darocur^{®} 1173 von Ciba), 2-Chlorthioxanthon (CTX von Lambson), Benzophenon, 2,4,6-Trimethylbenzoldiphenylphosphinoxid (TPO von BASF oder OMNIRAD ^{®} TPO von IGM Resins), Ethyl-2,4,6-trimethylbenzoylphenylphosphinat (TPO-L von BASF) und Methylbenzoylformiat (MBF von Lambson) und Kombinationen von zwei oder mehreren der zuvor genannten.

Die Gesamtmenge an Photoinitiatoren beträgt vorzugsweise 1 bis 12 Gew.-%, bevorzugt 3 bis 9 Gew.-%, bezogen auf Gewicht der Drucksubstanz.

Ferner kann vorgesehen sein, dass die Drucksubstanz mindestens ein Farbmittel, vorzugsweise ein Pigment und/oder einen Farbstoff umfasst, vorzugsweise mindestens ein Pigment.

Bei den Pigmenten, die in der erfindungsgemäßen Drucksubstanz vorzugsweise enthalten sind, kann es sich um beliebige Pigmente handeln, z.B. um Titandioxid, Zinksulfid, Pigmentruß, Azodiarylgelb, Isoindolgelb, Diarylidorange, Chinacridonmagenta, Diketopyrrolorot, Kupferphthalocyaninblau, Kupferphthalocyaningrün, Dioxazinviolett und Diketometalloxid. Eine ziemlich umfassende Auflistung weiterer einsetzbarer Pigmente ist im Colour Index International, Fourth Edition Online, 2001, veröffentlicht von der Society of Dyers and Colourists in Verbindung mit der American Association of Textile Chemists and Colorists zu finden. Es können auch Effektpigmente, wie Metalloxid-beschichtete Glimmer und Metallicpigmente, eingesetzt werden. Auch Edelmetallpulver oder Mattierungsmittel, wie Silikate und/oder natürliche und/oder synthetisch hergestellte Füllstoffe wie beispielsweise Calciumcarbonat, Bariumsulfat, Talkum, zur Beeinflussung der physikalischen und chemischen Eigenschaften wie Glanz, Härte, Brechungsindex, Chemikalienbeständigkeit etc. können eingesetzt werden.

Die Menge an Buntpigment beträgt gewöhnlich 1 bis 40 Gew.-%, bevorzugt 2 bis 35 Gew.-%, bezogen auf das Gewicht der Drucksubstanz, abhängig von der Art des Pigments und der gewünschten Deckkraft. Weißpigment wird gewöhnlich in einer Menge von 5 bis 40 Gew.-%, bevorzugt 10 bis 30 Gew.-%, eingesetzt.

Überraschende Vorteile können dadurch erzielt werden, dass das Pigment in einem härtbaren Monomer oder Oligomer dispergiert ist, vorzugweise in einem radikalisch oder kationisch härtbaren Monomer oder Oligomer, besonders bevorzugt einem (Meth)acrylat.

Im Allgemeinen kann eine erfindungsgemäße Drucksubstanz weitere übliche Additive enthalten. Hierzu gehören unter anderem Entschäumer, Verlaufsmittel, Netzmittel, Rheologieadditive und/oder Stabilisatoren, bevorzugt in einer Menge von 0,1 bis 10 Gew.-%, besonders bevorzugt 0,2 bis 5 und speziell bevorzugt 0,3 bis 2,5 Gew.-%, bezogen auf die Gesamtmasse der Drucksubstanz. Entschäumer können z.B. aus modifizierten Acrylaten oder modifizierten Acrylatcopolymeren, aber auch, und das bevorzugt, aus silikonhaltigen Verbindungen ausgewählt sein. Verlaufsmittel umfassen beispielsweise modifizierte Polyacrylate und Polysiloxane.

Rheolgieadditive umfassen beispielsweise Verbindungen auf Basis von Rizinusölen, Harnstoff, Polyurethane oder Polyamide.

Als Stabilisatoren werden bevorzugt Genorad 16 von der Fa. Rahn und Fluorstab UV2 von der Fa. Kromachem, 10, Park Industrial Centre, Tolpits Lane, Watford, Hertfordshire WD1 8SP, UK, verwendet

Weiterhin kann die Drucksubstanz organische Lösungsmittel und/oder Wasser enthalten. Hierdurch kann die Verarbeitbarkeit verbessert werden. Andererseits sind organische Lösungsmittel und/oder Wasser mit Nachteilen behaftet. So verschlechtert sich die Härtung durch die Verwendung von Wasser in der Drucksubstanz. Organische Lösungsmittel sind Verbindungen, die Kohlenstoff und Wasserstoffatome enthalten und nach dem Auftragen der Drucksubstanz aus der Beschichtung verdampfen. Reaktivverdünner, wie die Komponenten A) bis C), die flüssig sind, zählen dementsprechend nicht zu den organischen Lösungsmitteln. Organische Lösungsmittel reagieren dementsprechend durch die Härtung nicht mit weiteren Komponenten der Drucksubstanz. Vorzugsweise beträgt Wasseranteil der Drucksubstanz höchstens 4 Gew. %, vorzugsweise höchstens 2 Gew. % und besonders bevorzugt höchstens 1 Gew. %. Besonders bevorzugt umfasst die Drucksubstanz keine wesentlichen Anteile an Wasser. Bevorzugt beträgt der Anteil an organischem Lösungsmittel in der Drucksubstanz höchstens 4 Gew. %, vorzugsweise höchstens 2 Gew. % und besonders bevorzugt höchstens 1 Gew. %. Besonders bevorzugt umfasst die Drucksubstanz keine wesentlichen Anteile an organischem Lösungsmittel.

In einer bevorzugten Ausgestaltung ist die Drucksubstanz für Tintenstrahldruckverfahren (Inkjet-Verfahren) geeignet. Daher kann vorgesehen sein, dass die Drucksubstanz, vorzugsweise die Tinte eine Viskosität im Bereich von 3 mPas bis 100 mPas bei einer Scherung von 600 s⁻¹ und 23°C aufweist, gemessen mit Kegel/Platte am Rotationsviskosimeter.

In einer weiteren Ausgestaltung ist die Drucksubstanz für Siebdruckverfahren geeignet. Daher kann vorgesehen sein, dass die Drucksubstanz, vorzugsweise die Paste eine Viskosität im Bereich von 1 Pas bis 15 Pas bei einer Scherung von 200 s⁻¹ und 23°C aufweist, gemessen mit Kegel/Platte am Rotationsviskosimeter.

In einer weiteren Ausgestaltung ist die Drucksubstanz für Spritzverfahren geeignet. Daher kann vorgesehen sein, dass die Drucksubstanz, vorzugsweise die Paste eine Viskosität im Bereich von 1 mPas bis 350 mPas bei einer Scherung von 200 s⁻¹ und 23°C aufweist, gemessen mit Kegel/Platte am Rotationsviskosimeter.

Vorzugsweise kann vorgesehen sein, dass die Drucksubstanz mindestens 60 Gew.-%, vorzugsweise mindestens 70 Gew.-%, besonders bevorzugt mindestens 80 Gew.-% an Komponenten A), B), C) und D) umfasst.

Bevorzugt kann vorgesehen sein, dass die Drucksubstanz mindestens 70 Gew.-%, vorzugsweise mindestens 80 Gew.-%, besonders bevorzugt mindestens 90 Gew.-% an Feststoff und Komponenten A), B), C) und D) umfasst.

Ein weiterer Gegenstand der vorliegenden Erfindung ist eine UV-Tinte zur Beschichtung von Oberflächen, vorzugsweise Kunststoffoberflächen oder Glasoberflächen, besonders bevorzugt Glasoberflächen mit einem Tintenstrahldruckverfahren, umfassend
A) zumindest ein Monomer mit mindestens einer C-C-Doppelbindung;
B) zumindest ein kationisch härtbares Monomer, welches Epoxygruppen umfasst;
C) zumindest ein kationisch härtbares Monomer, welches Oxetangruppen umfasst;
D) zumindest einen Haftvermittler;
E) zumindest ein Pigment und/oder einen Farbstoff, vorzugsweise mindestens ein Pigment;
F) zumindest einen Photoinitiator, vorzugsweise einen UV-Initiator. UV-Initiator, wobei die Komponenten A) und D) wie in Anspruch 1 definiert sind.

Bevorzugt kann vorgesehen sein, dass die UV-Tinte mindestens 75 Gew.-%, vorzugsweise mindestens 85 Gew.-%, besonders bevorzugt mindestens 95 Gew.-% an Komponenten A), B), C), D), E) und F) umfasst.

Ein weiterer Gegenstand der vorliegenden Erfindung ist eine UV-Tinte zur Beschichtung von Oberflächen, vorzugsweise Kunststoffoberflächen oder Glasoberflächen, besonders bevorzugt Glasoberflächen mit einem Tintenstrahldruckverfahren, umfassend
A) zumindest ein Monomer mit mindestens einer C-C-Doppelbindung;
B) zumindest ein kationisch härtbares Monomer, welches Epoxygruppen umfasst;
C) zumindest ein kationisch härtbares Monomer, welches Oxetangruppen umfasst;
D) zumindest einen Haftvermittler;
F) zumindest einen Photoinitiator, vorzugsweise einen UV-Initiator, wobei die Komponenten A) und D) wie in Anspruch 1 definiert sind.

Bevorzugt kann vorgesehen sein, dass die UV-Tinte mindestens 75 Gew.-%, vorzugsweise mindestens 85 Gew.-%, besonders bevorzugt mindestens 95 Gew.-% an Komponenten A), B), C), D) und F) umfasst.

Besonders bevorzugt umfasst die UV-Tinte einen Sensibilisator. Durch den Einsatz Sensibilisatoren kann überraschend eine Härtung durch eine UV-LED-Lampe erzielt werden. LED-Lampen sind im Vergleich zu anderen Lampen, beispielsweise Quecksilberlampen sehr energiesparend.

Ein bevorzugter Gegenstand der vorliegenden Erfindung ist eine UV-Tinte zur Beschichtung von Oberflächen, vorzugsweise Kunststoffoberflächen oder Glasoberflächen, besonders bevorzugt Glasoberflächen mit einem Tintenstrahldruckverfahren, umfassend
A) zumindest ein Monomer mit mindestens einer C-C-Doppelbindung;;
B) zumindest ein kationisch härtbares Monomer, welches Epoxygruppen umfasst;
C) zumindest ein kationisch härtbares Monomer, welches Oxetangruppen umfasst;
D) zumindest einen Haftvermittler;
E) zumindest ein Pigment und/oder einen Farbstoff, vorzugsweise mindestens ein Pigment;
F) zumindest einen Photoinitiator, vorzugsweise einen UV-Initiator;
G) zumindest einen Sensibilisator, wobei die Komponenten A) und D) wie in Anspruch 1 definiert sind.

Bevorzugt kann vorgesehen sein, dass die UV-Tinte mindestens 80 Gew.-%, vorzugsweise mindestens 90 Gew.-%, besonders bevorzugt mindestens 95 Gew.-% an Komponenten A), B), C), D), E), F) und G) umfasst.

Ein bevorzugter Gegenstand der vorliegenden Erfindung ist eine UV-Tinte zur Beschichtung von Oberflächen, vorzugsweise Kunststoffoberflächen oder Glasoberflächen, besonders bevorzugt Glasoberflächen mit einem Tintenstrahldruckverfahren, umfassend
A) zumindest ein Monomer mit mindestens einer C-C-Doppelbindung;;
B) zumindest ein kationisch härtbares Monomer, welches Epoxygruppen umfasst;
C) zumindest ein kationisch härtbares Monomer, welches Oxetangruppen umfasst;
D) zumindest einen Haftvermittler;
F) zumindest einen Photoinitiator, vorzugsweise einen UV-Initiator;
G) zumindest einen Sensibilisator, wobei die Komponenten A) und D) wie in Anspruch 1 definiert sind.

Bevorzugt kann vorgesehen sein, dass die UV-Tinte mindestens 80 Gew.-%, vorzugsweise mindestens 90 Gew.-%, besonders bevorzugt mindestens 95 Gew.-% an Komponenten A), B), C), D), F) und G) umfasst.

UV-Tinten zur Beschichtung von Glasoberflächen mit einem Tintenstrahldruckverfahren die kein Pigment und/oder keinen Farbstoff umfassen, eignen sich insbesondere zur Erzeugung von Reliefs (farblose Erhöhungen) auf einem Substrat.

Die oben genannten Komponenten A) bis F) beziehungsweise A) bis G) werden zuvor ausführlich beschrieben, so dass hierauf Bezug genommen wird, wobei die genannten Bevorzugungen und bevorzugten Ausführungsformen dieser Komponenten ebenfalls auf eine UV-Tinte zutreffend sind.

Ein weiterer Gegenstand der vorliegenden Erfindung ist ein Verfahren zur Herstellung einer Drucksubstanz zur Beschichtung von Glasoberflächen mit einem Tintenstrahldruckverfahren. Dieses Verfahren ist dadurch gekennzeichnet, dass die Komponenten A), B), C) und D) gemischt werden, vorzugsweise die Komponenten A), B), C), D), E) und F) oder A), B), C), D) und F) und besonders bevorzugt die Komponenten A), B), C), D), E), F) und G) oder A), B), C), D), F) und G). In einer bevorzugten Ausgestaltung des erfindungsgemäßen Verfahrens wird vorzugsweise ein Pigment in Form einer Dispersion und/oder Suspension zugegeben, welche ein Monomer umfasst, vorzugweise ein Monomer mit mindestens einer C-C-Doppelbindung.

Ferner kann vorgesehen sein, dass die Drucksubstanz, vorzugsweise die UV-Tinte nur geringe Mengen an einem oder mehreren Modifikatoren umfasst. Vorzugsweise umfasst die Drucksubstanz, vorzugsweise die UV-Tinte höchstens 1 Gew.-%, besonders bevorzugt höchtens 0,8 Gew.-% an einem oder mehreren Modifikatoren. Modifikatoren sind insbesondere Polyole mit einem Hydroxylwert von 40 bis 330 mg KOH / g; Polyole mit einem Hydroxylwert von 40 bis 330 mg KOH / g und einem Säurewert von 2 bis 20 mg KOH / g; modifizierte Kautschuke und/oder Verbindungen mit einem Epoxyäquivalent von 150 bis 700 g / mol. Modifizierte Kautschuke sind insbesondere carboxylierte Polyisoprene und/oder carboxylierte Polybutadiene. Besonders bevorzugt umfasst die Drucksubstanz, vorzugsweise die UV-Tinte keine wesentlichen Mengen an einem oder mehreren Modifikatoren.

Ferner kann vorgesehen sein, dass die Drucksubstanz, vorzugsweise die UV-Tinte nur geringe Mengen an einem oder mehreren Basengeneratoren umfasst. Vorzugsweise umfasst die Drucksubstanz, vorzugsweise die UV-Tinte höchstens 1 Gew.-%, besonders bevorzugt höchtens 0,8 Gew.-% an einem oder mehreren Basengeneratoren. Ein Basengenerator ist eine Verbindung, die eine Base erzeugt, wenn sie aktiven Strahlen, Radikalen oder einer Base ausgesetzt wird. Insbesondere sind Basengeneratoren bekannte Verbindungen wie Basengeneratoren, die eine Base bei Bestrahlung erzeugen, Basisgeneratoren, die eine Base erzeugen, falls diese Radikalen ausgesetzt werden, und Basengeneratoren, die eine Base erzeugen, falls diese mit einer Base in Kontakt gebracht werden. Zum Beispiel erzeugen Oximderivate, quartäre Ammoniumsalze und quartäre Amidinsalze jeweils eine Base, wenn sie entweder aktiven Strahlen oder Radikalen ausgesetzt sind, und daher kann jedes dieser Derivate sowohl als Basisgenerator, der eine Base erzeugt, falls dieser bestrahlt wird, als auch als Basisgenerator, der eine Base erzeugt, falls dieser Radikalen ausgesetzt wird, verwendet werden. Carbamat-Derivate erzeugen eine Base, wenn sie einer Base ausgesetzt werden. Besonders bevorzugt umfasst die Drucksubstanz, vorzugsweise die UV-Tinte keine wesentlichen Mengen an einem oder mehreren Modifikatoren.

Ferner kann vorgesehen sein, dass die Drucksubstanz, vorzugsweise die UV-Tinte nur geringe Mengen an einem oder mehreren Alkylencarbonaten oder Butyrolacton enthalten. Beispielhafte Alkylencarbonate sind u.a. Glycerincarbonate, Ethylencarbonat, Propylencarbonat, Butylencarbonat und Kombinationen, die mindestens einen der vorgenannten Stoffe enthalten. Vorzugsweise umfasst die Drucksubstanz, vorzugsweise die UV-Tinte höchstens 1 Gew.-%, besonders bevorzugt höchtens 0,8 Gew.-% an einem oder mehreren einem oder mehreren Alkylencarbonaten oder Butyrolacton. Besonders bevorzugt umfasst die Drucksubstanz, vorzugsweise die UV-Tinte keine wesentlichen Mengen an einem oder mehreren Alkylencarbonaten oder Butyrolacton.

Ferner kann vorgesehen sein, dass die Drucksubstanz, vorzugsweise die UV-Tinte nur geringe Mengen an einem oder mehreren Acrylatester eines Carbonsäureesters umfasst. Vorzugsweise umfasst die Drucksubstanz, vorzugsweise die UV-Tinte höchstens 1 Gew.-%, besonders bevorzugt höchtens 0,4 Gew.-% an einem oder mehreren Acrylatester eines Carbonsäureesters. Acrylatester eines Carbonsäureesters sind Verbindungen, die neben einer Acrylatgruppe zusätzlich eine Estergruppe umfasst, so dass die Alkoholgruppe des Acrylats zusätzlich eine Estergruppe umfasst. Besonders bevorzugt umfasst die Drucksubstanz, vorzugsweise die UV-Tinte keine wesentlichen Mengen an einem oder mehreren Acrylatester eines Carbonsäureesters.

Ferner kann vorgesehen sein, dass die Drucksubstanz, vorzugsweise die UV-Tinte nur geringe Mengen an einem oder mehreren rein thermischen Initiatoren umfasst, wobei diese thermischen Initiatoren sowohl eine radikalische als auch eine kationische Polymerisation initiieren können. Vorzugsweise umfasst die Drucksubstanz, vorzugsweise die UV-Tinte höchstens 1 Gew.-%, besonders bevorzugt höchtens 0,4 Gew.-% an einem oder mehreren rein thermischen Initiatoren. Rein thermische Initiatoren sind Verbindungen, die bei Erwärmung eine radikalische als auch eine kationische Polymerisation initiieren können, jedoch bei einer Bestrahlung mit UV-Licht keine radikalische als auch eine kationische Polymerisation initiieren. Der Begriff "rein thermische Initiatoren" stellt insbesondere eine Abgrenzung gegenüber den bevorzugt einzusetzenden UV-Initiatoren dar, so dass UV-Initiatoren, die bei Erwärmen eine Polymerisation auslösen, keine rein thermischen Initiatoren darstellen. Besonders bevorzugt umfasst die Drucksubstanz, vorzugsweise die UV-Tinte keine wesentlichen Mengen an einem oder mehreren rein thermischen Initiatoren.

Ein weiterer Gegenstand der vorliegenden Erfindung ist die Verwendung einer erfindungsgemäßen Drucksubstanz, die dadurch gekennzeichnet ist, dass die Drucksubstanz auf Glas, Keramik, Metall, Holz oder Kunststoff aufgetragen wird, vorzugsweise auf Glas oder Kunststoff, besonders bevorzugt auf Glas. Der Ausdruck "Glas", wie er in den Ansprüchen und der Beschreibung verwendet wird, soll Glas, Keramik, Fliesenglasuren und ähnlich glasartige Materialien bedeuten.

Die zu bedruckenden Gegenstände können in jeder Form oder Gestalt vorliegen, wie einem Behälter, einer Platte, einer Fliese, einer Figur usw. Eine bevorzugte Ausführungsform der Erfindung ist Verpackungs- (Getränkeflaschen, Kosmetikbehälter) und Wirtschaftsglas (z.B. Saftglas).

In einer bevorzugten Ausgestaltung der vorliegenden Verwendung kann vorgesehen sein, dass die Drucksubstanz mit einem Tintenstrahldruckverfahren auf ein Substrat, vorzugsweise auf Glas aufgetragen wird.

In einer weiterhin bevorzugten Ausgestaltung der vorliegenden Verwendung kann vorgesehen sein, dass nach der Auftragung der Drucksubstanzen (sowohl neben- als auch übereinander) auf ein Substrat, vorzugsweise auf Glas, keine weitere Schicht, zum Beispiel in Form eines klaren Decklackes, zum Schutze der darunterliegenden Tinte aufgetragen wird.

Ferner kann vorgesehen sein, dass vor Auftragung der Drucksubstanz auf ein Substrat, vorzugsweise auf Glas, keine Schicht aufgetragen wird, vorzugsweise unbehandeltes Glas bedruckt wird. Weiterhin kann vorgesehen sein, dass das Substrat, vorzugsweise das Glas einer Vorbehandlung (Beflammung und / oder Silanbeflammung) unterzogen wird. Eine Vorbehandlung ist jedoch nicht zwingend notwendig, wie dies die Beispieldaten zeigen.

Weiterhin kann vorgesehen sein, dass die Drucksubstanz in einer Atmosphäre aufgetragen wird, die eine relative Luftfeuchtigkeit im Bereich von 25% bis 50 % aufweist.

Darüber hinaus kann vorgesehen sein, dass die Drucksubstanz bei einer Temperatur aufgetragen wird, die im Bereich von 10 bis 60 °C, vorzugsweise 15 bis 55°C und besonders bevorzugt 20 bis 50°C liegt.

Die Härtung der Drucksubstanz wird vorzugsweise mit UV-Licht in einem Wellenlängenbereich von 160 bis 420 nm über eine Zeitspanne vorgenommen, die ausreichend ist, um eine vollständige Härtung zu erzielen. Alternativ kann die Drucksubstanz auch ohne Photoinitiatoren mit Elektronenstrahlen gehärtet werden. Ferner kann die Drucksubstanz auch mit thermischen Initiatoren versehen werden und entsprechend gehärtet werden. Zur UV-Härtung können übliche UV-Lichtquellen, wie Quecksilberdampflampen (auch eisen- oder galliumdotiert), Halogenmetalldampflampen, Quarzlampen, Excimerlaser oder UV-Leuchtdioden (UV-LEDs) eingesetzt werden.

Hierbei kann die Härtung über einen rein kationischen Mechanismus erfolgen, so dass lediglich Initiatoren, vorzugsweise Photoinitiatoren für eine kationische Reaktion verwendet werden. In einer bevorzugten Ausführungsform wird eine Härtung über einen radikalischen und einen kationischen Mechanismus erzielt, so dass sowohl ein Initiator für eine kationische Polymerisation als auch ein Initiator für eine radikalische Polymerisation verwendet werden.

Nachfolgend wird die vorliegende Erfindung anhand von Beispielen näher erläutert, ohne dass hierdurch eine Begrenzung der Erfindung erfolgen soll.

### Testverfahren

### Daumendreh-Test

Die lackierte Glasplatte wird nach der UV-Härtung direkt vom Band genommen. Mithilfe eines Tuchs wird unter festem Druck eine Drehbewegung mit dem Daumen auf der frisch gehärteten Tinte ausgeführt. Der entstandene Abdruck wird nach untenstehendem Schema beurteilt.
5 = Ablösung der Beschichtung bis aufs Glas
4 = starker Abdruck (tlw. bis aufs Glas)
3 = gut erkennbarer Abdruck
2 = leichter Abdruck
1 = kaum erkennbarer Abdruck, nur durch Ausspiegeln der Oberfläche erkennbar.
0 = kein Abdruck

### Gitterschnitt-Versuch

Mit dem Gitterschnittprüfer (Klingenabstand 1 mm) wird ein Kreuz auf der gehärteten Oberfläche bis zum Substrat eingeritzt. Anschließend wird ein Klebeband auf das Gitterkreuz geklebt, fest angedrückt und im Anschluss schnell abgezogen. Die Beurteilung erfolgt nach untenstehendem Schema von 0 (keinerlei Haftverlust) bis 5 (Komplettablösung)
5 = Komplettablösung auch über den Gitterschnitt hinaus.
4 = Ablösung im Gitterschnitt
3 = Ablösung 30 - 50%
2 = Ablösung 10-30 %
1 = Ablösung am Schnitt <10%
0 = keine Ablösung

### Double Rub Ethanol-Versuch

Ein Tuch wird über einen Hammer mit einem Gewicht von 0,5 kg mit Kabelbinder fixiert. Das Tuch wird anschließend mit Ethanol angefeuchtet, bis das Tuch vollkommen vollgesaugt ist. Der Hammer wird ohne Druck (nur mit seinem Eigengewicht) über die Oberfläche geführt. Falls das Tuch trocken wird, sollte es nach 20 bis 50-Doppelhüben nochmals angefeuchtet werden. Notiert werden die Anzahl der Doppelhübe bis die Beschichtung angegriffen wird.

### Cold water Test

Eine Dose wird mit VE-Wasser gefüllt. Die lackierten Glasplatten werden so in die Dose gestellt, dass die lackierte Fläche in offenem Kontakt mit dem Wasser ist. Anschließend wird die Dose verschlossen und für eine bestimmte Zeit in den Kühlschrank bei einer Temperatur zwischen 4 bis 10°C gestellt.

### Pasteurisation

Ein Topf wird mit VE-Wasser gefüllt. Wasser wird auf 70°C erhitzt. Die lackierten Glasplatten werden so in den Topf gestellt, dass die lackierte Fläche in offenem Kontakt mit dem Wasser ist. Nach 30 min werden die Glasplatten entnommen und geprüft.

### Ausführungsbeipiele 1 und 2 und Vergleichsbeispiele 1 und 2

Die in nachfolgender Tabelle dargelegten Drucksubstanzen werden durch Mischen hergestellt,
Vorbehandlung des Flachglases (Luft- als auch Badseite): Reinigung zuerst mit Ethanol, dann mit Ethylacetat.
Auftrag mit Rakel: 8µm Spiralrakel der Firma BYK
Nassfilmdicke pro Schicht 8-12µm. Gemessen mit Nassfilmdickenmesser Erichsen Model: 234 R/I
Lampe: Fa. Höhnle UV Technology (LED-Powerline PLD), Wassergekühlt, Wellenlänge: 385nm

Die Dosis beträgt 380 - 420 mJ/cm², gemessen mit PUK (Fa. Kühnast Strahlungstechnik) UV-Integrator.

| | **Beispiel 1** | **Vergleichsbeispiel 1** | **Beispiel 2** | **Vergleichsbeispiel 2** |
|---|---|---|---|---|
| Farbe | Weiß | Weiß | Cyan | Cyan |
| Bestandteile | Gew.-% | Gew.-% | Gew.-% | Gew.-% |
| Cycloaliphatisches Epoxid | 6,87 | 7,77 | 8,80 | 9,96 |
| Aliphatisches Epoxid, Glycidylether mit zwei Epoxygruppen | 6,38 | 7,19 | 5,28 | 5,99 |
| Aliphatisches Epoxid, Glycidylether mit drei Epoxygruppen | 7,56 | 8,34 | 6,65 | 7,53 |
| Oxetan mit zwei Oxetangruppen | 6,87 | 7,78 | 8,81 | 10,01 |
| Vinylether mit einer Vinylgruppe | 3,93 | 4,47 | 5,28 | 6,02 |
| Vinylether mit zwei Vinylgruppen | 14,48 | 15,56 | 18,59 | 21,06 |
| Cyclisches Acrylat (nicht-vernetzend) | 14,74 | 16,65 | 19,56 | 22,34 |
| Polyvinylbutyral | | | 1,96 | 3,37 |
| Kationischer Initiator; Diaryliodoniumsalz | 5,89 | 6,66 | 3,67 | 4,14 |
| Sensibilisator; UV-Radikalinitiator Thioxanthon | 1,97 | 2,22 | 1,22 | 1,39 |
| Verlaufsmittel auf Siliconbasis | 0,39 | 0,46 | 0,39 | 0,44 |
| Rheologieadditiv | 1,0 | 1,15 | | |
| Epoxysilane; | 9,84 | | 9,79 | |
| In Acrylaten dispergiertes Weißpigment | 20,07 | 21,76 | | |
| In Acrylaten dispergiertes Cyanpigment | | | 10,00 | 7,75 |
| Summe | 100,00 | 100,00 | 100,00 | 100,00 |

Die auf einer Glasplatte erhaltenen Beschichtungen werden durch den Gitterschnitt-Versuch und den Double Rub Ethanol-Versuch getestet, wobei die in der nachfolgenden Tabelle dargelegten Ergebnisse erzielt werden:

| | Beispiel 1 | Beispiel 1 | Vergleichs beispiel 1 | Vergleichs beispiel 1 | Beispiel 2 | Vergleichs beispiel 2 |
|---|---|---|---|---|---|---|
| Seite des Flachglases | Luftseite | Badseite | Luftseite | Badseite | Luftseite | Luftseite |
| Gitterschnitt nach Härtung | 0 | 0 | 2-3 | 5 | 0-1 | 3 |
| Double Rub Ethanol 24 h nach Härtung | >50 | >50 | 30 | 22 | >50 | 25 |

Die Beispiele zeigen, dass durch die Zugabe von Haftvermittlern überraschende Steigerungen in der Lösungsmittelbeständigkeit erreicht werden können.

Referenzbeispiel 3, Ausführungsbeispiel 4 und Vergleichsbeispiel 3

Die in nachfolgender Tabelle dargelegten Drucksubstanzen werden durch Mischen hergestellt, mittels Tintenstrahldruck auf ein Glassubstrat (Flachglas) aufgetragen und wie zuvor dargelegt gehärtet (Beispiel 3 ist ein Referenzbeispiel):

| | **Beispiel 3** | **Beispiel 4** | **Vergleichsbeispiel 3** |
|---|---|---|---|
| Farbe | Weiß | Weiß | Weiß |
| Bestandteile | Gew.-% | Gew.-% | Gew.-% |
| Cycloaliphatisches Epoxid | 9,50 | 7,03 | 9,35 |
| Aliphatisches Epoxid, Glycidylether mit zwei Epoxygruppen | 5,50 | 6,58 | 8,75 |
| Aliphatisches Epoxid, Glycidylether mit drei Epoxygruppen | 7,23 | 7,72 | 10,26 |
| Oxetan mit zwei Oxetangruppen | 9,49 | 7,03 | 0,00 |
| Vinylether mit einer Vinylgruppe | 5,51 | 4,08 | 4,08 |
| Vinylether mit zwei Vinylgruppen | 20,37 | 14,72 | 14,72 |
| Cyclisches Acrylat (nicht-vernetzend) | | 15,36 | 15,36 |
| Kationischer Initiator; Diaryliodoniumsalz | 5,99 | 5,70 | 5,70 |
| Sensibilisator; UV-Radikalinitiator Thioxanthon | 2,00 | 1,90 | 1,90 |
| Verlaufsmittel auf Siliconbasis | 0,41 | 0,38 | 0,38 |
| Epoxysilane; | 10,02 | 9,5 | 9,5 |
| In Acrylaten dispergiertes Weißpigment | | 20,00 | 20,00 |
| In cycloaliphatischem Epoxid und Vinylether dispergiertes Weißpigment | 23,97 | | |
| Summe | 100,00 | 100,00 | 100,00 |

Die auf einer Glasplatte erhaltenen Beschichtungen wurden durch den Gitterschnitt-Versuch und den Double Rub Ethanol-Versuch getestet, wobei die in der nachfolgenden Tabelle dargelegten Ergebnisse erzielt werden:

| | Beispiel 3 | Beispiel 3 | Beispiel 4 | Beispiel 4 | Vergleichs beispiel 3 | Vergleichs beispiel 3 |
|---|---|---|---|---|---|---|
| Seite des Flachglases | Luftseite | Badseite | Luftseite | Badseite | Luftseite | Badseite |
| Gitterschnitt nach Härtung | 2-3 | 4 | 0-1 | 2-3 | 3-4 | 5 |
| Gitterschnitt nach 30 Minuten in Wasser bei 70°C | 2-3 | 5 | 0 | 0-1 | 5 | 5 |
| Double Rub Ethanol 24 h nach Härtung | 50 | 40 | | | | |

Die Beispiele und das Vergleichsbeispiel zeigen, dass durch die Verwendung von kationisch härtbaren Monomeren mit Oxetangruppen wesentlich höhere Haftfestigkeiten erreicht werden können. Ferner zeigen Drucksubstanzen mit Acrylaten bessere Haftfestigkeiten als Drucksubstanzen ohne Acrylate.

### Ausführungsbeipiele 5 bis 9

Die in nachfolgender Tabelle dargelegten Drucksubstanzen werden durch Mischen hergestellt, mittels Tintenstrahldruck auf ein Glassubstrat (Flachglas) aufgetragen und wie zuvor dargelegt gehärtet:

| | **Beispiel 5** | **Beispiel 6** | **Beispiel 7** | **Beispiel 8** | **Beispiel 9** |
|---|---|---|---|---|---|
| Verhältnis von Epoxy zu Oxetan -Gruppen bezogen auf Gew.-% | 1:0,33 | 1:1,79 | 1:0,6 | 1:0,14 | 1:2,13 |

| Bestandteile | Gew.-% | Gew.-% | Gew.-% | Gew.-% | Gew.-% |
|---|---|---|---|---|---|
| Cycloaliphatisches Epoxid | 6,23 | 1,33 | 4,67 | 7,79 | 0,85 |
| Aliphatisches Epoxid, Glycidylether mit zwei Epoxygruppen | 5,83 | 1,25 | 4,37 | 7,29 | 0,80 |
| Aliphatisches Epoxid, Glycidylether mit drei Epoxygruppen | 6,84 | 1,47 | 5,13 | 8,55 | 0,93 |
| Oxetan mit zwei Oxetangruppen | 9,46 | 24,31 | 14,19 | 4,73 | 25,78 |
| Vinylether mit einer Vinylgruppe | 4,08 | 4,08 | 4,08 | 4,08 | 4,08 |
| Vinylether mit zwei Vinylgruppen | 14,72 | 14,72 | 14,72 | 14,72 | 14,72 |
| Cyclisches Acrylat (nicht-vernetzend) | 15,36 | 15,36 | 15,36 | 15,36 | 15,36 |
| Kationischer Initiator; Diaryliodoniumsalz | 5,7 | 5,7 | 5,7 | 5,7 | 5,7 |
| Sensibilisator; UV-Radikalinitiator Thioxanthon | 1,9 | 1,9 | 1,9 | 1,9 | 1,9 |
| Verlaufsmittel auf Siliconbasis | 0,38 | 0,38 | 0,38 | 0,38 | 0,38 |
| Epoxysilane; | 9,5 | 9,5 | 9,5 | 9,5 | 9,5 |
| In Acrylaten dispergiertes Weißpigment | 20,00 | 20,00 | 20,00 | 20,00 | 20,00 |
| Summe | 100,00 | 100,00 | 100,00 | 100,00 | 100,00 |

Die auf einer Glasplatte erhaltenen Beschichtungen werden durch den Gitterschnitt-Versuch getestet, wobei die in der nachfolgenden Tabelle dargelegten Ergebnisse erzielt werden:

| | Beispiel 5 | Beispiel 6 | Beispiel 7 | Beispiel 8 | Beispiel 9 |
|---|---|---|---|---|---|
| Seite des Flachglases | Badseite | Badseite | Badseite | Badseite | Badseite |
| Gitterschnitt nach Härtung | 5 | 5 | 5 | 5 | 5 |
| Gitterschnitt 24 Stunden nach Härtung | 0 | 1,5 | 0 | 0,5 | 0,5 |
| Gitterschnitt nach 3 Tagen in kaltem Wasser (7°C) | 2 | 5 | 4 | 3 | 5 |

### Ausführungsbeipiele 10 bis 15

Die in nachfolgender Tabelle dargelegten Drucksubstanzen werden durch Mischen hergestellt, mittels Tintenstrahldruck auf ein Glassubstrat (Flachglas) aufgetragen und wie zuvor dargelegt gehärtet:

| | **Beispiel 10** | **Beispiel 11** | **Beispiel 12** |
|---|---|---|---|
| Verhältnis von Epoxy zu Oxetan -Gruppen bezogen auf Gew.-% | 1:0,29 | 1:0,33 | 1:1,81 |
| Bestandteile | Gew.-% | Gew.-% | Gew.-% |
| Cycloaliphatisches Epoxid | 9,0 | 8,55 | 1,83 |
| Aliphatisches Epoxid, Glycidylether mit zwei Epoxygruppen | 5,4 | 5,13 | 1,10 |
| Aliphatisches Epoxid, Glycidylether mit drei Epoxygruppen | 6,8 | 6,45 | 1,38 |
| Oxetan mit zwei Oxetangruppen | 9,0 | 10,07 | 25,89 |
| Vinylether mit einer Vinylgruppe | 5,4 | 5,4 | 5,4 |
| Vinylether mit zwei Vinylgruppen | 19,0 | 19,0 | 19,0 |
| Cyclisches Acrylat (nicht-vernetzend) | 20,0 | 20,0 | 20,0 |
| Polyvinylbuteral | 3,0 | 3,0 | 3,0 |
| Kationischer Initiator; Diaryliodoniumsalz | 3,8 | 3,8 | 3,8 |
| Sensibilisator; UV-Radikalinitiator Thioxanthon | 1,3 | 1,3 | 1,3 |
| Verlaufsmittel auf Siliconbasis | 0,4 | 0,4 | 0,4 |
| Epoxysilane; | 10,0 | 10,0 | 10,0 |
| In Acrylaten dispergiertes Cyanpigment | 7,0 | 7,0 | 7,0 |
| Summe | 100,00 | 100,00 | 100,00 |

| | **Beispiel 13** | **Beispiel 14** | **Beispiel 15** |
|---|---|---|---|
| Verhältnis von Epoxy zu Oxetan -Gruppen bezogen auf Gew.-% | 1:0,60 | 1:0,14 | 1:2,15 |
| Bestandteile | Gew.-% | Gew.-% | Gew.-% |
| Cycloaliphatisches Epoxid | 6,41 | 10,69 | 1,17 |
| Aliphatisches Epoxid, Glycidylether mit zwei Epoxygruppen | 3,85 | 6,41 | 0,70 |
| Aliphatisches Epoxid, Glycidylether mit drei Epoxygruppen | 4,84 | 8,07 | 0,88 |
| Oxetan mit zwei Oxetangruppen | 15,1 | 5,03 | 27,45 |
| Vinylether mit einer Vinylgruppe | 5,4 | 5,4 | 5,4 |
| Vinylether mit zwei Vinylgruppen | 19,0 | 19,0 | 19,0 |
| Cyclisches Acrylat (nicht-vernetzend) | 20,0 | 20,0 | 20,0 |
| Polyvinylbutyral | 3,0 | 3,0 | 3,0 |
| Kationischer Initiator; Diaryliodoniumsalz | 3,8 | 3,8 | 3,8 |
| Sensibilisator; UV-Radikalinitiator Thioxanthon | 1,3 | 1,3 | 1,3 |
| Verlaufsmittel auf Siliconbasis | 0,4 | 0,4 | 0,4 |
| Epoxysilane; | 10,0 | 10,0 | 10,0 |
| | | | |
| In Acrylaten dispergiertes Cyanpigment | 7,0 | 7,0 | 7,0 |
| Summe | 100,00 | 100,00 | 100,00 |

Die auf einer Glasplatte erhaltenen Beschichtungen werden durch den Gitterschnitt-Versuch und den Daumendreh-Test getestet, wobei die in der nachfolgenden Tabelle dargelegten Ergebnisse erzielt werden:

| | Beispiel 10 | Beispiel 11 | Beispiel 12 | Beispiel 13 | Beispiel 14 | Beispiel 15 |
|---|---|---|---|---|---|---|
| Seite des Flachglases | Badseite | Badseite | Badseite | Badseite | Badseite | Badseite |
| Gitterschnitt nach Härtung | 3 | 3 | 5 | 4 | 3,5 | 5 |
| Gitterschnitt 24 Stunden nach Härtung | 0 | 0 | 0 | 0 | 0 | 0 |
| Gitterschnitt nach 3 Tagen in kaltem Wasser (7°C) | 2 | 3 | 5 | 5 | 0 | 5 |
| Daumendreh-Test | 1 | 1 | 0 | 0 | 2 | 0 |

### Ausführungsbeipiele 16 und 17

Die in nachfolgender Tabelle dargelegten Drucksubstanzen werden durch Mischen hergestellt, mittels Tintenstrahldruck auf ein Glassubstrat (Flachglas) aufgetragen und gehärtet:

| | **Beispiel 16** | **Beispiel 17** |
|---|---|---|
| Bestandteile | Gew.-% | Gew.-% |
| Cycloaliphatisches Epoxid | 7,24 | 7,12 |
| Aliphatisches Epoxid, Glycidylether mit zwei Epoxygruppen | 6,73 | 6,61 |
| Aliphatisches Epoxid, Glycidylether mit drei Epoxygruppen | 7,97 | 7,83 |
| Oxetan mit zwei Oxetangruppen | 7,24 | 7,12 |
| Vinylether mit einer Vinylgruppe | 4,14 | 4,07 |
| Vinylether mit zwei Vinylgruppen | 14,90 | 14,65 |
| Cyclisches Acrylat (nicht-vernetzend) | 15,52 | 15,26 |
| Kationischer Initiator; Diaryliodoniumsalz | 6,21 | 6,10 |
| Sensibilisator; UV-Radikalinitiator Thioxanthon | 2,07 | 2,04 |
| Verlaufsmittel auf Siliconbasis | 0,41 | 0,41 |
| Rheologieadditiv | 0,66 | 0,71 |
| Epoxysilane; | 10,34 | 10,17 |
| In Acrylaten dispergiertes Weißpigment | 16,57 | 17,91 |
| Summe | 100,00 | 100,00 |

Die Beispiel 16 dargelegte Beschichtungszusammensetzung wurde bei einer relativen Luftfeuchtigkeit oberhalb von ca. 60 % gehärtet (Raumtemperatur), wobei über einen relativ langen Zeitraum gehärtet wurde, ohne dass ein zweckmäßiger Grad der Härtung erzielt wurde. Die im Wesentlichen gleiche Zusammensetzung gemäß Beispiel 17 wurde bei einer relativen Luftfeuchtigkeit von ca. 32 % gehärtet (Raumtemperatur), wobei in kurzer Zeit eine gute Härtung erzielt wurde. Aufgrund der schlechten Härtung wurden keine Versuche mit der gemäß Beispiel 16 erhaltenen Beschichtung durchgeführt.

| | Beispiel 17 | Beispiel 17 |
|---|---|---|
| Seite des Flachglases | Luftseite | Badseite |
| Gitterschnitt nach Härtung | 0 | 1 |
| Gitterschnitt nach 30 Minuten in Wasser bei 70°C | 0 | 0 |
| Double Rub Ethanol 24 h nach Härtung | >100 | >100 |

Die Beispiele zeigen, dass durch die vorliegende Erfindung die zuvor dargelegten Aufgaben gelöst werden, insbesondere die Haftung und die Stabilität eines durch die erfindungsgemäße Drucksubstanz erhaltenen Dekors überraschend deutlich gesteigert werden kann, ohne dass andere Eigenschaften der Drucksubstanz oder des Dekors hierdurch nachteilig beeinflusst werden.

## Patentansprüche

1. Drucksubstanz zur Beschichtung von Oberflächen, vorzugsweise Glasoberflächen mit einem Tintenstrahldruckverfahren, umfassend
A) zumindest ein Monomer mit mindestens einer C-C-Doppelbindung;
B) zumindest ein kationisch härtbares Monomer, welches Epoxygruppen umfasst;
C) zumindest ein kationisch härtbares Monomer, welches Oxetangruppen umfasst;
D) zumindest einen Haftvermittler,
**dadurch gekennzeichnet, dass**
das Monomer mit mindestens einer C-C-Doppelbindung eine Mischung darstellt, die mindestens ein (Meth)acrylat und mindestens ein Vinylethermonomer umfasst, wobei das Monomer mit mindestens einer C-C-Doppelbindung mindestens ein cyclisches (Meth)acrylat umfasst und
der Haftvermittler mindestens eine Silanverbindung umfasst.

2. Drucksubstanz gemäß Anspruch 1, **dadurch gekennzeichnet, dass** das Monomer mit mindestens einer C-C-Doppelbindung mindestens ein vernetzendes Monomer umfasst.

3. Drucksubstanz gemäß Anspruch 1 oder 2, **dadurch gekennzeichnet, dass** der Haftvermittler aus einer oder mehreren Silanverbindungen besteht.

4. Drucksubstanz gemäß mindestens einem der vorhergehenden Ansprüche, **dadurch gekennzeichnet, dass** die Drucksubstanz mindestens 5 Gew.-%, vorzugsweise mindestens 6 Gew.-% und besonders bevorzugt mindestens 7 Gew.-% Haftvermittler umfasst.

5. Drucksubstanz gemäß mindestens einem der vorhergehenden Ansprüche, **dadurch gekennzeichnet, dass** das kationisch härtbare Monomer, welches Epoxygruppen umfasst, mindestens ein Monomer mit zwei Epoxygruppen enthält.

6. Drucksubstanz gemäß mindestens einem der vorhergehenden Ansprüche, **dadurch gekennzeichnet, dass** das kationisch härtbare Monomer, welches Oxetangruppen umfasst, mindestens ein Monomer mit mindestens zwei Oxetangruppen aufweist.

7. Drucksubstanz gemäß mindestens einem der vorhergehenden Ansprüche, **dadurch gekennzeichnet, dass** das molare Verhältnis von Monomer, welches Epoxygruppen umfasst, zu Monomer, welches Oxetangruppen umfasst, im Bereich von 40:1 bis 1:15, vorzugsweise 30:1 bis 1:10, bevorzugt 25:1 bis 1:8, besonders bevorzugt 20:1 bis 1:5, speziell bevorzugt 10:1 bis 1:1, besonders speziell bevorzugt 6:1 bis 2:1 und ganz bevorzugt 4:1 bis 9:4 liegt.

8. Drucksubstanz gemäß mindestens einem der vorhergehenden Ansprüche, **dadurch gekennzeichnet, dass** das molare Verhältnis von Monomer mit mindestens einer C-C-Doppelbindung zu kationisch härtbarem Monomer mit einer Epoxy- und/oder Oxetangruppe im Bereich von 20:1 bis 1:5, vorzugsweise 10:1 bis 1:3, besonders bevorzugt 5:1 bis 1:2 und speziell bevorzugt 2:1 bis 1:1 liegt.

9. Drucksubstanz gemäß mindestens einem der vorhergehenden Ansprüche, **dadurch gekennzeichnet, dass** der Wasseranteil der Drucksubstanz höchstens 4 Gew.-%, vorzugsweise höchstens 2 Gew.-% und besonders bevorzugt höchstens 1 Gew.-% beträgt, wobei die Drucksubstanz ganz besonders bevorzugt keine wesentlichen Anteile an Wasser enthält.

10. Drucksubstanz gemäß mindestens einem der vorhergehenden Ansprüche, **dadurch gekennzeichnet, dass** der Anteil an organischem Lösungsmittel in der Drucksubstanz höchstens 4 Gew. %, vorzugsweise höchstens 2 Gew. % und besonders bevorzugt höchstens 1 Gew. % beträgt, wobei die Drucksubstanz ganz besonders bevorzugt keine wesentlichen Anteile an organischem Lösungsmittel enthält.

11. Drucksubstanz gemäß mindestens einem der vorhergehenden Ansprüche, **dadurch gekennzeichnet, dass** der Haftvermittler eine härtbare Gruppe umfasst.

12. Drucksubstanz gemäß mindestens einem der vorhergehenden Ansprüche, **dadurch gekennzeichnet, dass** die Drucksubstanz mindestens 60 Gew.-%, vorzugsweise mindestens 70 Gew.-%, besonders bevorzugt mindestens 80 Gew.-% an Komponenten A), B), C) und D) umfasst.

13. Drucksubstanz gemäß mindestens einem der vorhergehenden Ansprüche, **dadurch gekennzeichnet, dass** die Drucksubstanz mindestens einen Initiator, vorzugsweise einen Photoinitiator umfasst.

14. Drucksubstanz gemäß mindestens einem der vorhergehenden Ansprüche, **dadurch gekennzeichnet, dass** das molare Verhältnis von (Meth)acrylat zu Vinylethermonomer im Bereich von 20:1 bis 1:20, vorzugsweise im Bereich von 6:1 bis 1:6, besonders bevorzugt im Bereich von 2:1 bis 1:2 liegt

15. Verfahren zur Herstellung einer Drucksubstanz gemäß mindestens einem der vorhergehenden Ansprüche, **dadurch gekennzeichnet, dass** die Komponenten A), B), C) und D) gemischt werden.

16. Verwendung einer Drucksubstanz gemäß einem der vorhergehenden Ansprüche 1 bis 14, **dadurch gekennzeichnet, dass** die Drucksubstanz auf Glas, Keramik, Metall, Holz oder Kunststoff aufgetragen wird, vorzugsweise auf Glas.

17. Verwendung gemäß Anspruch 16, **dadurch gekennzeichnet, dass** die Drucksubstanz mit einem Tintenstrahldruckverfahren auf ein Substrat, vorzugsweise auf Glas aufgetragen wird.

18. Verwendung gemäß Anspruch 16 oder 17, **dadurch gekennzeichnet, dass** die Drucksubstanz in einer Atmosphäre aufgetragen wird, die eine relative Luftfeuchtigkeit im Bereich von 25% bis 50 % aufweist.

19. Verwendung gemäß einem der Ansprüche 16 bis 18, **dadurch gekennzeichnet, dass** nach der Auftragung der Drucksubstanz auf ein Substrat, vorzugsweise auf Glas, keine weitere Schicht aufgetragen wird.

20. Verwendung gemäß einem der Ansprüche 16 bis 19, **dadurch gekennzeichnet, dass** vor Auftragung der der Drucksubstanz auf ein Substrat, vorzugsweise auf Glas, keine Schicht aufgetragen wird, vorzugsweise unbehandeltes Glas oder beflammtes Glas bedruckt wird.

## Claims

1. Printing substance for coating surfaces, preferably glass surfaces with an inkjet printing process, comprising
A) at least one monomer with at least one C-C double bond;
B) at least one cationic hardenable monomer comprising epoxy groups;
C) at least one cationic hardenable monomer comprising oxetane groups;
D) at least an adhesion promoter,
**characterized in that**
the monomer with at least one C-C double bond is a mixture which comprises at least one (meth)acrylate and at least one vinyl ether monomer, wherein the monomer having at least one C-C double bond comprises at least one cyclic (meth)acrylate and the adhesion promoter comprises at least one silane compound.

2. Printing substance according to claim 1, **characterized in that** the monomer with at least one C-C double bond comprises at least one crosslinking monomer.

3. Printing substance according to claim 1 or 2, **characterized in that** the adhesion promoter consists of one or more silane compounds.

4. Printing substance according to at least one of the previous claims, **characterized in that** the printing substance contains at least 5% by weight, preferably at least 6 % by weight and particularly preferably at least 7 % by weight, of an adhesion promoter.

5. Printing substance according to at least one of the preceding claims, **characterized in that** the cationic hardenable monomer which comprises epoxy groups contains at least one monomer with two epoxy groups.

6. Printing substance according to at least one of the previous claims, **characterized in that** the cationic hardenable monomer, which comprises oxetane groups comprises at least one monomer having at least two oxetane groups.

7. Printing substance according to at least one of the previous claims, **characterized in that** the molar ratio of monomer comprising epoxy groups to monomer comprising oxetane groups is in the range from 40:1 to 1:15, preferably 30:1 to 1:10, more preferably from 25:1 to 1:8,particularly preferably 20:1 to 1:5, especially preferably 10:1 to 1:1, particularly preferably 6:1 to 2:1 and most preferably 4:1 to 9:4.

8. Printing substance according to at least one of the previous claims, **characterized in that** the molar ratio of monomer having at least one C-C double bond to cationic hardenable monomer with an epoxy and/or oxetane group is in the range from 20:1 to 1:5, preferably 10:1 to 1:3, particularly preferably 5:1 to 1:2 and especially preferably 2:1 to 1:1.

9. Printing substance according to at least one of the previous claims, **characterized in that** the water content of the printing substance is at most 4 % by weight, preferably at most 2 % by weight and particularly preferably at most 1% by weight, wherein the printing substance very particularly preferably does not contain any significant proportion of water.

10. Printing substance according to at least one of the previous claims, **characterized in that** the proportion of organic solvent in the printing substance is at most 4% by weight, preferably at most 2% by weight and particularly preferably at most 1% by weight, wherein the printing substance particularly preferably contains no substantial amounts of organic solvent.

11. Printing substance according to at least one of the previous claims, **characterized in that** the adhesion promoter comprises a hardenable group.

12. Printing substance according to at least one of the previous claims, **characterized in that** the printing substance contains at least 60 % by weight, preferably at least 70 % by weight, particularly preferably at least 80 % by weight of components A), B), C) and D).

13. Printing substance according to at least one of the previous claims, **characterized in that** the printing substance comprises at least one initiator, preferably a photoinitiator.

14. Printing substance according to at least one of the previous claims, **characterized in that** the molar ratio of (meth)acrylate to vinyl ether monomer is in the range from 20:1 to 1:20, preferably in the range from 6:1 to 1:6, particularly preferably in the range from 2:1 to 1:2.

15. Process for preparing a printing substance according to at least one of the previous claims, **characterized in that** the components A), B), C) and D) are mixed.

16. Use of a printing substance according to one of the previous claims 1 to 14, **characterized in that** the printing substance is applied to glass, ceramic, metal, wood or plastic, preferably on glass.

17. Use according to claim 16, **characterized in that** the printing substance is applied to a substrate using an inkjet printing process, preferably on glass.

18. Use according to claim 16 or 17, **characterized in that** the printing substance is applied in an atmosphere which has a relative humidity in the range from 25% to 50%.

19. Use according to one of claims 16 to 18, **characterized in that** after the printing substance has been applied to a substrate, preferably on glass, no further layer is applied.

20. Use according to one of claims 16 to 19, **characterized in that**, before the printing substance is applied to a substrate preferably on glass, no layer is applied, preferably untreated glass or flamed glass is being coated.

## Revendications

1. Substance d'impression pour le revêtement de surfaces, de préférence de surfaces en verre, par un procédé d'impression par jet d'encre, comprenant
A) au moins un monomère avec au moins une double liaison C-C ;
B) au moins un monomère cationiquement durcissable, qui comprend des groupes époxy;
C) au moins un monomère cationiquement durcissable, qui comprend des groupes oxétane ;
D) au moins un promoteur d'adhésion,
**caractérisé en ce que**
le monomère avec au moins une double liaison C-C represente un mélange qui comprend au moins un (méth)acrylate et au moins un monomère d'éther vinylique, dans lequel le monomère avec au moins une double liaison C-C comprend au moins un (méth)acrylate cyclique et le promoteur d'adhésion comprend au moins un composé de silane.

2. Substance d'impression selon la revendication 1, **caractérisée en ce que** le monomère avec au moins une double liaison C-C comprend au moins un monomère de réticulation.

3. Substance d'impression selon la revendication 1 ou 2, **caractérisée en ce que** le promoteur d'adhésion est constitué d'un ou plusieurs composés de silane.

4. Substance d'impression selon au moins l'une des revendications précédentes, **caractérisée en ce que** la substance d'impression comprend au moins 5 % en poids, de préférence au moins 6 % en poids et de manière particulièrement préférée au moins 7 % en poids de promoteur d'adhésion.

5. Substance d'impression selon au moins l'une des revendications précédentes, **caractérisée en ce que** le monomère cationiquement durcissable, qui comprend des groupes époxy, contient au moins un monomère avec deux groupes époxy.

6. Substance d'impression selon au moins une des revendications précédentes, **caractérisée en ce que** le monomère cationiquement durcissable, qui comprend des groupes oxétane, présente au moins un monomère avec au moins deux groupes oxétane.

7. Substance d'impression selon au moins l'une des revendications précédentes, **caractérisée en ce que** le rapport molaire entre le monomère, qui comprend des groupes époxy, et le monomère, qui comprend des groupes oxétane, est compris dans la plage de 40:1 à 1:15, de préférence de 30:1 à 1:10, de manière préférée de 25:1 à 1:8, de manière particulièrement préférée de 20:1 à 1:5, de manière spécialement préférée de 10:1 à 1:1, de manière particulièrement spécialement préférée de 6:1 à 2:1 et de manière tout à fait préférée de 4:1 à 9:4.

8. Substance d'impression selon au moins l'une des revendications précédentes, **caractérisée en ce que** le rapport molaire entre le monomère avec au moins une double liaison C-C et le monomère cationiquement durcissable avec un groupe époxy et/ou oxétane se situe dans la plage de 20:1 à 1:5, de préférence de 10:1 à 1:3, de manière particulièrement préférée de 5:1 à 1:2 et de manière spécialement préférée de 2:1 à 1:1.

9. Substance d'impression selon au moins l'une des revendications précédentes, **caractérisée en ce que** la teneur en eau de la substance d'impression est d'au plus 4 % en poids, de préférence d'au plus 2 % en poids et de manière particulièrement préférée d'au plus 1 % en poids, dans laquelle la substance d'impression ne contient de manière tout à fait préférée aucune proportion importante d'eau.

10. Substance d'impression selon au moins l'une des revendications précédentes, **caractérisée en ce que** la proportion de solvant organique dans la substance d'impression est d'au plus 4 % en poids, de préférence d'au plus 2 % en poids et de manière particulièrement préférée d'au plus 1 % en poids, dans laquelle la substance d'impression ne contient de manière tout à fait préférée, aucune proportion importante de solvant organique.

11. Substance d'impression selon au moins l'une des revendications précédentes, **caractérisée en ce que** le promoteur d'adhésion comprend un groupe durcissable.

12. Substance d'impression selon au moins une des revendications précédentes, **caractérisée en ce que** la substance d'impression comprend au moins 60 % en poids, de préférence au moins 70 % en poids, de manière particulièrement préférée au moins 80 % en poids de composants A), B), C) et D).

13. Substance d'impression selon au moins l'une des revendications précédentes, **caractérisée en ce que** la substance d'impression comprend au moins un initiateur, de préférence un photoinitiateur.

14. Substance d'impression selon au moins l'une des revendications précédentes, **caractérisée en ce que** le rapport molaire du (méth)acrylate au monomère éther vinylique se situe dans la plage de 20:1 à 1:20, de préférence dans la plage de 6:1 à 1:6, de manière particulièrement préférée dans la plage de 2:1 à 1:2.

15. Procédé de préparation d'une substance d'impression selon au moins l'une des revendications précédentes, **caractérisé en ce que** les composants A), B), C) et D) sont mélangés.

16. Utilisation d'une substance d'impression selon l'une quelconque des revendications précédentes 1 à 14, **caractérisée en ce que** la substance d'impression est appliquée sur du verre, de la céramique, du métal, du bois ou du plastique, de préférence sur du verre.

17. Utilisation selon la revendication 16, **caractérisée en ce que** la substance d'impression est appliquée sur un substrat, de préférence sur du verre, par un procédé d'impression à jet d'encre.

18. Utilisation selon la revendication 16 ou 17, **caractérisée en ce que** la substance d'impression est appliquée dans une atmosphère qui présente une humidité relative de l'air comprise entre 25% et 50%.

19. Utilisation selon l'une des revendications 16 ou 18, **caractérisée en ce qu'**aucune autre couche n'est appliquée après l'application de la substance d'impression sur un substrat, de préférence sur du verre.

20. Utilisation selon l'une des revendications 16 à 19, **caractérisée en ce qu'**aucune couche n'est appliquée avant l'application de la substance d'impression sur un substrat, de préférence sur du verre, de préférence en imprimant sur du verre non traité ou sur du verre flammé.
